# EUROPEAN PATENT SPECIFICATION

(11) **EP 4 030 700 B1**
(45) Date of publication and mention of the grant of the patent: **26.03.2025**
(21) Application number: 21876736.6
(22) Date of filing: 10.08.2021
(51) Int. Cl.: H04L 12/40, H01M 10/42, H02J 7/00

(54) **METHOD FOR ALLOCATING COMMUNICATION ID AND SYSTEM PROVIDING THE METHOD**
VERFAHREN ZUR ZUWEISUNG EINER KOMMUNIKATIONSKENNUNG UND SYSTEM ZUR DURCHFÜHRUNG DES VERFAHRENS
PROCÉDÉ D'ATTRIBUTION D'UN IDENTIFIANT DE COMMUNICATION ET SYSTÈME FOURNISSANT LA MÉTHODE

(30) Priority: 09.11.2020 KR 20200148613
(43) Date of publication of application: 20.07.2022
(73) Proprietor: LG ENERGY SOLUTION, LTD., Seoul 07335 (KR)
(72) Inventor: YOON, Sunwoo, Daejeon 34122 (KR); LEE, Jung Su, Daejeon 34122 (KR)
(74) Representative: Plasseraud IP
(86) International application number: PCT/KR2021/010604
(87) International publication number: WO 2022/097884

(56) References cited:
- KR-A- 20130 095 424
- KR-A- 20170 052 954
- KR-A- 20200 040 504
- KR-A- 20200 086 956
- KR-B1- 102 123 671
- US-A1- 2014 091 769
- US-A1- 2015 316 974
- US-A1- 2018 233 928

## Description

### BACKGROUND OF THE INVENTION

### (a) Field of the Invention

### [Technical Field]

The present invention relates to a method for allocating a communication ID for communication between a master battery management system (BMS) and a plurality of slave BMSs, and a system for providing the method.

### [Background Art]

Electric vehicles (EV), such as hybrid vehicles (HV), plug-in hybrid electric vehicles (PHEV), or battery electric vehicles (BEV), may be driven with a high voltage battery. To provide high-voltage power, a battery system may include a battery pack configured by connecting a plurality of battery modules in series or in parallel, and the battery pack may include a battery management system (BMS).

The battery management system (BMS) may include a plurality of slave BMSs for monitoring and managing a plurality of battery modules, and a master BMS for managing the slave BMS in an integrated way. The slave BMSs may transmit battery data including a battery cell voltage and temperature information to the master BMS according to various communication methods. For example, the slave BMSs may communicate with the master BMS by CAN communication that belongs to communication methods performed in the vehicle.

When the CAN communication method is used, the slave BMSs performing a same operation are coupled in parallel, so it is needed to allocate communication IDs for distinguishing the slave BMSs.

Conventionally, when the slave BMSs and the master BMS are connected in an earlier stage, a manual allocation method for an expert engineer to set present configuration positions of the slave BMSs and communication connecting IDs is used, or a method for applying predetermined voltages to the slave BMSs, sequentially waking up the same, and allocating the communication ID is used.

However, regarding the method for manually allocating the communication ID, times of allocating communication IDs become different depending on skill levels of the expert engineer, and he may erroneously set the same when he is not skilled in the method. The method for sequentially allocating the communication IDs needs an additional circuit for applying a voltage, and it is difficult to reduce the time of allocating the communication ID according to the sequential allocation.

Further background art is described in US 2015/316974 A1.

### [Disclosure]

The present invention has been made in an effort to provide a communication ID allocating method for a plurality of slave BMSs to allocate communication IDs based on a current amount applied through a power line, and a system for providing the method.

The present invention is defined in the appended independent claims to which reference should be made. Advantageous features are set out in the appended dependent claims.

The present invention may allocate the communication IDs by using the installed power line, so it needs no additional device (e.g., a circuit, a switch) for allocating communication IDs to thus reduce the cost, and the circuit of the device to which the communication ID allocating system or the system may not be complicated.

The present invention allows the plurality of slave BMSs to automatically allocate their own communication IDs, thereby reducing the time of allocating the communication IDs.

According to the present invention, the communication ID corresponding to the first current amount may be preset and may be stored in the master BMS, so the master BMS may receive the calculated first current amount and the allocated communication ID from the slave BMSs after the communication ID is set, thereby easily verifying the allocation of communication IDs.

### [Description of the Drawings]

FIG. 1 shows a system for allocating communication IDs according to an embodiment.
FIG. 2 shows a detailed block diagram on a configuration of a master BMS of FIG. 1.
FIG. 3 shows a detailed block diagram on a configuration of a slave BMS of FIG. 1.
FIG. 4 shows a block diagram on a plurality of slave BMSs sequentially connected to a power line and a corresponding difference of a first current amount according to an embodiment.
FIG. 5 shows a circuit diagram of a top-level slave BMS shown in FIG. 4.
FIG. 6 shows a flowchart of a method for allocating communication IDs according to an embodiment.
FIG. 7 shows a detailed flowchart of allocating CAN communication IDs of FIG. 6 (S200).

### [Mode for Invention]

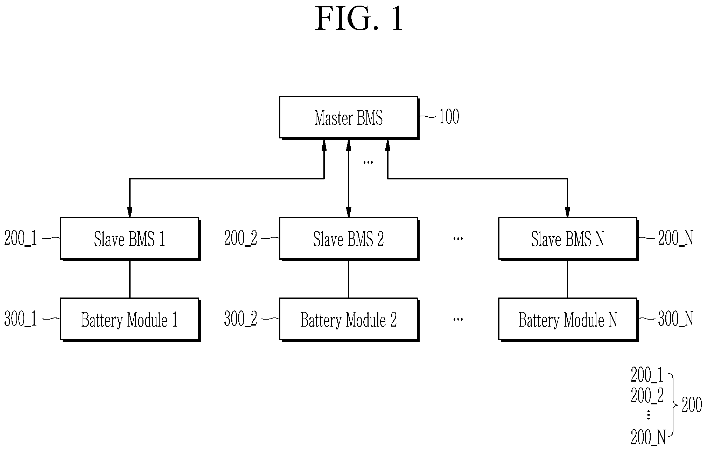

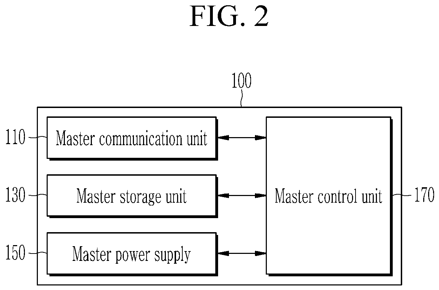

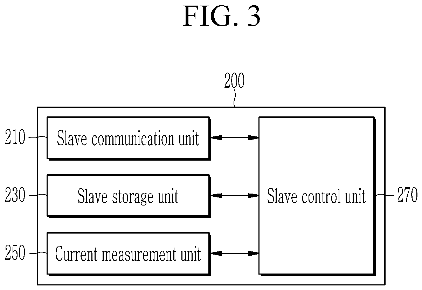

FIG. 1 shows a system for allocating communication IDs according to an embodiment, FIG. 2 shows a detailed block diagram on a configuration of a master BMS of FIG. 1, and FIG. 3 shows a detailed block diagram on a configuration of a slave BMS of FIG. 1.

Referring to FIG. 1, the system for allocating communication IDs includes a master BMS 100 and a plurality of slave BMSs 200_1 to 200_N.

The system for allocating communication IDs is not limited to titles of the master BMS 100 and the slave BMSs 200_1 to 200_N, and it may be applied to or included in a system including a plurality of control devices and a higher-level control device for managing the control devices in an integrated way. For example, the system for allocating communication IDs may be applied to or included in a battery system or an energy storage system (ESS), but is not limited thereto.

The master BMS 100 may be a higher-level control device for controlling the slave BMSs 200_1 to 200_N in an integrated way. For this purpose, the master BMS 100 may communicate with the slave BMSs 200_1 to 200_N so as to request necessary information and receive it. The master BMS 100 may perform 1:1 communication or 1:N communication with the slave BMSs 200_1 to 200_N according to a controller area network (CAN) communication method, and may identify the slave BMSs 200_1 to 200_N through the communication IDs.

Referring to FIG. 2, the master BMS 100 may include a master communication unit 110, a master storage unit 130, a master power unit 150, and a master control unit 170.

The master communication unit 110 may include a communication module for communicating with the slave BMSs 200_1 to 200_N. Depending on embodiments, the master communication unit 110 may include a CAN communication module.

The master storage unit 130 may store a number (N) of the slave BMSs 200_1 to 200_N, a plurality of first current amounts applied to the respective slave BMSs 200_1 to 200_N, and a communication ID allocating table on which a plurality of communication IDs corresponding to the first current amounts are recorded.

The master power unit 150 may supply a power voltage to the slave BMSs 200_1 to 200_N. Depending on embodiments, a power source for supplying a power voltage to the slave BMSs 200_1 to 200_N may, for example, be a low voltage auxiliary battery that is different from the high voltage battery module 300. For another example, the power source may be realized with a master power unit 150 for supplying low-voltage power.

The master control unit 170 may generally control the master BMS 100, and may integrally manage the slave BMSs 200_1 to 200_N. Depending on embodiments, the master control unit 170 may broadcast a signal for instructing allocation of communication IDs in the case of first connection to the slave BMSs 200_1 to 200_N through the master communication unit 110. The slave BMSs 200_1 to 200_N connected to the master communication unit 110 through the network may automatically allocate the communication IDs.

Depending on embodiments, when receiving a power voltage from the power source, the master control unit 170 may broadcast a signal for instructing allocation of communication IDs through the master communication unit 110.

The slave BMS 200 may monitor and control the electrically connected battery module 300. For example, the slave BMSs 200_1 to 200_N may measure or predict states (e.g., a temperature, a voltage, and charging capacity) of the battery cell included in a plurality of battery modules 300_1 to 300_N and may send resultant signals to the master BMS 100. The slave BMS 200 may control (e.g., charge and discharge, planarize, etc.) the battery module 300 according to a control signal received from the master BMS 100.

Depending on embodiments, the slave BMSs 200_1 to 200_N may be sequentially connected to a power supplying line. For example, the first slave BMS 200_1 and the second slave BMS 200_2 may be connected thereto, and the second slave BMS 200_2 and the third slave BMS 200_3 may be sequentially connected thereto (i.e., the daisy chain method) to receive a consumed current. Accordingly, the respective slave BMSs 200 may output a second current amount that is generated by subtracting the consumed current amount used for driving from the first current amount applied through the power line through a power line.

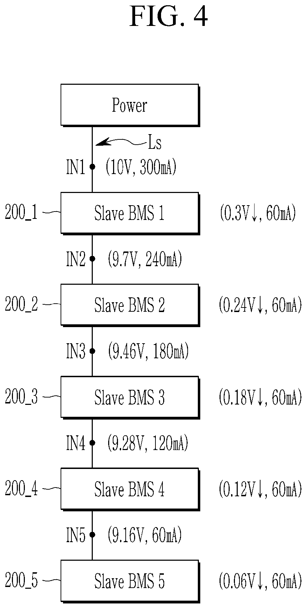

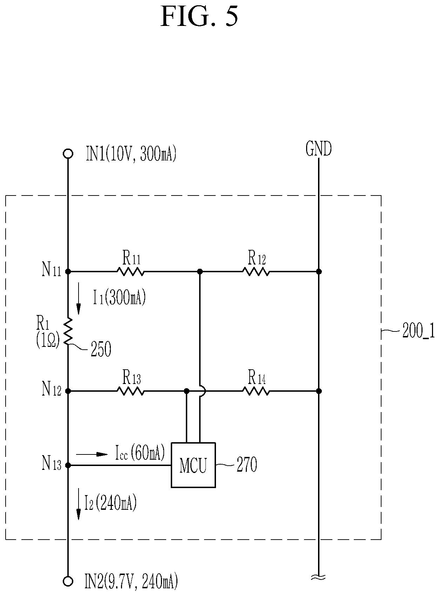

In detail, the first current amount applied to the uppermost first slave BMS 200_1 connected near the power source may correspond to the current amount that is a summation of the consumed current amounts of the slave BMSs 200_1 to 200_N. A second current amount output from the uppermost first slave BMS 200_1 may correspond to the current amount generated by subtracting the consumed current amount for driving the first slave BMS 200_1 from the first current amount. The first current amount applied to the lowermost N-th slave BMS 200_N may correspond to the consumed current amount for driving the N-th slave BMS 200_N. In this instance, the N-th slave BMS 200_N has no posterior slave BMS, so the second current amount output from the N-th slave BMS 200_N may not exist, which will be described in detail with reference to FIG. 4 and FIG. 5.

Referring to FIG. 3, the slave BMS 200 may include a slave communication unit 210, a slave storage unit 230, a current measurement unit 250, and a slave control unit 270.

The slave communication unit 210 may include a communication module for communicating with the master BMS 100. Depending on embodiments, the slave communication unit 210 may include a CAN communication module.

The slave storage unit 230 may store information for indicating resistance of the shunt resistor included in the current measurement unit 250, and a communication ID allocating table transmitted from the master BMS 100 through the slave communication unit 210.

The current measurement unit 250 includes a shunt resistor coupled in series to the power line, and provides a voltage value that corresponds to a voltage drop caused by the shunt resistor so as to measure a first current amount applied through the power line. For example, the slave control unit 270 may measure voltages at the front end and the rear end of the shunt resistor to calculate a voltage value that corresponds to the voltage drop, and substitutes the calculated voltage value and the resistance of the shunt resistor into Ohm's law to calculate the first current amount (current value).

The slave control unit 270 generally controls the slave BMS 200. Depending on embodiments, the slave control unit 270 may automatically allocate a predetermined communication ID as the communication ID of the slave control unit 270 based on the first current amount indicating relative positions among the slave BMSs 200_1 to 200_N.

FIG. 4 shows a block diagram on a plurality of slave BMSs sequentially connected to a power line and a corresponding difference of a first current amount according to an embodiment.

Referring to FIG. 4, for example, it will be assumed that the number (N) of the slave BMSs 200_1 to 200_N is 5, the power source supplies a power voltage that corresponds to a predetermined voltage value of 10 V and a predetermined current value of 300 mA, and the consumed current amounts of the respective slave BMSs 200_1 to 200_N are 60 mA. Here, the slave BMSs 200_1 to 200_N may have the same consumed current amount within a predetermined error range (e.g., ±10 mA).

Depending on embodiments, the first to fifth slave BMSs 200_1 to 200_N are sequentially connected to the power supplying line (Ls). In detail, the uppermost slave BMS 200 may be a first slave BMS 200_1 connected near the power source, and the second to fourth slaves BMS 200_2 to 200_4 may be sequentially connected to the first slave BMS 200_1. Here, the fifth slave BMS 200_5 may correspond to the lowermost slave BMS 200.

As they are sequentially connected to the power line (Ls), the respective first to fifth slave BMSs 200_1 to 200_N output the second current amount that is generated by subtracting the consumed current amount for driving from the first current amount applied through the power line (Ls) to the power line (Ls). A current input with reference to the predetermined slave BMS 200 is a first current, and a current output therewith is a second current.

In detail, the first current amount applied to the uppermost slave BMS 200_1 may correspond to the entire consumed current amount to be used by the slave BMSs 200_1 to 200_N, that is, the summation value of the consumed current amounts of the slave BMSs 200_1 to 200_N. The first current amounts applied to the respective slave BMSs are gradually reduced while passing through a plurality of intermediate slave BMSs 200_2 to 200_N-1 sequentially connected through the power line (Ls). The lowermost slave BMS 200_N may receive the first current amount corresponding to the consumed current amount to be used by the lowermost slave BMS 200_N. In this instance, the lowermost slave BMS 200_N has no posterior slave BMS, so there may be no second current amount output by the lowermost slave BMS 200_N.

For example, referring to FIG. 4, the first current amount applied to the first slave BMS 200_1 through a first input end (IN1) may be 300 mA that is the summation of the consumed current amount of 60 mA of the first to fifth slave BMSs 200_1 to 200_5. The second current amount output by the first slave BMS 200_1 may correspond to the current amount (240 mA = 300 mA - 60 mA) generated by subtracting the consumed current amount of 60 mA of the first slave BMS 200_1 from the first current amount of 300 mA. The consumed current amount of 60 mA is gradually reduced while passing through the second to fourth slave BMSs 200_2 to 200_4, and the first current amount is sequentially reduced (240 mA, 180 mA, and 120 mA) by the consumed current amount. The first current amount applied to the fifth slave BMS 200_5 may correspond to the consumed current amount of 60 mA of the fifth slave BMS 200_5.

As described above, the first current amount corresponds to the summation of the consumed current amounts of the slave BMS 200 for receiving the first current amount and the sequentially connected posterior slave BMS 200. Assuming that consumed current amounts of the respective slave BMSs 200 have a same value within a predetermined error range, the first current amount may indicate (or express) the relative positions of the slave BMSs 200_1 to 200_N.

Depending on embodiments, the first current amount (e.g., 300 mA) may be expressed as a predetermined multiple (300 mA/60 mA = 5) of the consumed current amount of 60 mA, and the predetermined multiple of 5 may correspond to the number (N=5) of the sequentially connected slave BMSs 200.

Referring to FIG. 4, the first current amount of 300 mA indicates that there are five (300 mA/60 mA = 5) slave BMSs 200 that are sequentially connected, so the slave BMS 200 receiving the first current amount of 300 mA may be a fifth slave BMS 200 from the lowermost slave BMS 200_5. In this instance, since the number (N) of the slave BMSs 200_1 to 200_N is 5, the slave BMS 200 receiving the first current amount of 300 mA may be the uppermost slave BMS 200_1. When calculated by the same method, the slave BMS 200 receiving the first current amount of 60 mA may be the lowermost slave BMS 200.

FIG. 5 shows a circuit diagram of a top-level slave BMS shown in FIG. 4.

Referring to FIG. 4 and FIG. 5, according to an embodiment, when the master BMS 100 broadcasts the signal for instructing allocation of communication IDs through a network, the first slave BMS 200_1 may calculate a first current amount (11) applied through the first input end (IN1) of the power line (LS), and may allocate a predetermined communication ID as the communication ID of the first slave BMS 200_1 based on the calculated first current amount (11). Depending on embodiments, a second current (12) output by the first slave BMS 200_1 through the power line (LS) may be applied as a first current of the second slave BMS 200_2.

The slave control unit 270 measures voltages at a first node N11 positioned at the front end of the shunt resistor R1 coupled in series to the power line (LS) and a second node N12 positioned at the rear end thereof. For example, the slave control unit 270 may reduce the voltages respectively measured at the first node N11 and the second node N12 into values that are within an input range, and may then receive them. For this purpose, a plurality of resistors R11 to R14 may be disposed in series and/or in parallel between the shunt resistor R1 and the slave control unit 270. For example, respective resistance of the resistors R11 to R14 may set so that the voltages (about 10 V and 9.7 V) measured at the first node N11 and the second node N12 may be reduced by the ratio of 1/10 (about 1 V and 0.97 V) and may be applied to the slave control unit 270. Depending on embodiments, the slave control unit 270 may be realized as a microcontroller unit (MCU).

The slave control unit 270 calculates a difference value (10 V - 9.7 V = 0.3 V) between the voltage value (e.g., 10 V) measured at the first node (N11) and the voltage value (e.g., 9.7 V) measured at the second node N12, that is, the voltage value (0.3 V) caused by a voltage drop (↓) of the shunt resistor R1. The slave control unit 270 may substitute (I=V/R) the resistance (e.g., 1 Ω) of the shunt resistor R1 stored in the slave storage unit 230 and the voltage value (0.3 V) caused by the voltage drop (↓) of the shunt resistor R1 into Ohm's law to calculate the first current amount (I = 0.3 V/1 Ω = 300 mA).

The slave control unit 270 may automatically allocate the communication ID that corresponds to the calculated first current amount of 300 mA as the communication ID of the slave control unit 270 based on the communication ID allocating table. The communication ID allocating table may, as expressed in Table 1, include a plurality of communication IDs that correspond to a plurality of first current amounts (11 to I5) respectively.

**(Table 1)**

| First current (I) | Communication IDs | Relative positions |
|---|---|---|
| 300 mA (11) | ID_1 | N=1 |
| 240 mA (12) | ID_2 | N=2 |
| 180 mA (13) | ID_3 | N=3 |
| 120 mA (14) | ID_4 | N=4 |
| 60 mA (15) | ID_5 | N=5 |

Referring to Table 1, the first slave BMS 200_1 corresponding to N=1 is the uppermost slave BMS 200, and the fifth slave BMS 200_5 corresponding to N=5 is the lowermost slave BMS 200. For example, the slave control unit 270 of the first slave BMS 200_1 may automatically allocate the first communication ID (ID_1) that corresponds to the calculated first current amount of 300 mA as the communication ID of the slave control unit 270 based on the communication ID allocating table.

Referring to FIG. 5, the slave control unit 270 may receive a current for driving, that is, the consumed current (Icc) from the third node N13 positioned at the rear end of the second node N12. For example, the consumed current amount (Icc) may be 60 mA. The second current amount (12) output by the first slave BMS 200_1 through the power line (LS) may correspond to the current amount (240 mA = 300 mA - 60 mA) that is the first current amount of 300 mA minus the consumed current amount 60 mA used by the first slave BMS 200_1.

Referring to FIG. 4 and FIG. 5, the second to fifth slave BMSs 200_2 to 200_5 may respectively include the same circuit configuration as the first slave BMS 200_1 described with reference to FIG. 5. The resistance (e.g., 1 Ω) of the shunt resistor R1 included in the respective second to fifth slave BMSs 200_2 to 200_5 may be the same. The respective second to fifth slave BMSs 200_2 to 200_5 may calculate the first current amounts (12 to I5) applied through the second to fifth input ends (IN2 to IN5) of the power line (LS).

Referring to FIG. 4, regarding the second slave BMS 200_2, the voltage value caused by the voltage drop (↓) of the shunt resistor R1 is 0.24 V (9.7 V - 9.46 V = 0.24 V). The first current amount (I = 0.24 V / 1 Ω = 240 mA) applied through the second input end (IN2) of the power line (LS) may be calculated by substituting (I=V/R) resistance of 1 Ω of the shunt resistor R1 and the voltage value of 0.24 V caused by the voltage drop (↓) of the shunt resistor R1 into Ohm's law. With the same calculation method, the first current amounts applied to the respective third to fifth slave BMSs 200_2 to 200_5 through the second to fifth input ends (IN2 to IN5) may be calculated to be 180 mA, 120 mA, and 60 mA as shown in FIG. 4.

The respective second to fifth slave BMSs 200_2 to 200_5 may automatically allocate the communication IDs (ID_2, ID_3, ID_4, and ID_5) that correspond to the calculated first current amounts of 240 mA, 180 mA, 120 mA, and 60 mA as the communication IDs of the second to fifth slave BMSs 200_2 to 200_5 based on the communication ID allocating table. The second slave BMS 200_2 may automatically allocate the second communication ID (ID_2) as the communication ID of the second slave BMS 200_2. In a like way, the third slave BMS 200_3 to fifth slave BMS 200_5 may automatically allocate the third communication ID (ID_3), the fourth communication ID (ID_4), and the fifth communication ID (ID_5) as the communication IDs of the third slave BMS 200_3 to the fifth slave BMS 200_5.

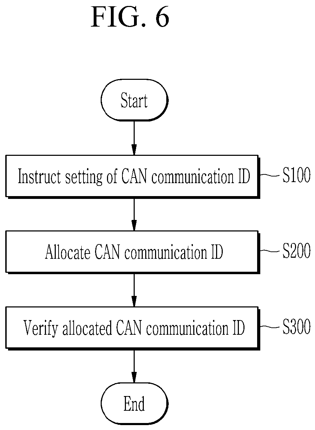

FIG. 6 shows a flowchart of a method for allocating communication IDs according to an embodiment.

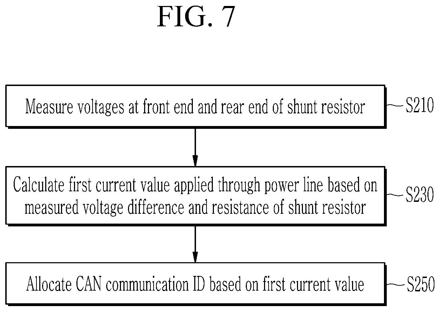

FIG. 7 shows a detailed flowchart of allocating CAN communication IDs of FIG. 6 (S200). A method for allocating communication IDs will now be described with reference to FIG. 1 to FIG. 7.

Referring to FIG. 6, the master BMS 100 may broadcast a signal for instructing allocation of communication IDs through the network in the case of the first connection to the slave BMSs 200_1 to 200_N (S100).

In order for the master BMS 100 to communicate with the slave BMSs 200_1 to 200_N, communication IDs for identifying the slave BMSs 200_1 to 200_N are needed. However, the master BMS 100 may not specify the respective slave BMSs 200_1 to 200_N and may not transmit signals before the communication IDs are allocated, so it may broadcast the communication ID allocating instruction to the slave BMSs 200_1 to 200_N through the network.

Depending on embodiments, the master BMS 100 may broadcast the signal for instructing allocation of communication IDs when power is supplied from the power source through a power line.

The slave BMS 200 may allocate a predetermined communication ID as the communication ID of the slave BMS 200 based on the first current amount applied through the power line (S200).

Depending on embodiments, the slave BMSs 200_1 to 200_N are sequentially connected to the power line for supplying power. The slave BMSs 200_1 to 200_N may output the second current amount that is the first current amount minus the consumed current amount for driving through the power line. For example, the first current amount may correspond to the summation value of the consumed current amount of the slave BMS 200 receiving the first current amount and the consumed current amount of at least one posterior slave BMS 200 sequentially connected to the slave BMS 200 receiving the first current amount.

Referring to FIG. 6, in S200, the slave BMS 200 may measure the voltages at the front end and the rear end of the shunt resistor R1 coupled in series to the power line and may calculate the voltage value caused by the voltage drop (S210).

The slave control unit 270 may measure the voltages at the first node N11 of the front end of the shunt resistor R1 coupled in series to the power line (LS) and the second node N12 of the rear end thereof. Referring to FIG. 5, for example, the slave control unit 270 included in the first slave BMS 200_1 may calculate the difference value (10 V - 9.7 V = 0.3 V) between the voltage value (e.g., 10 V) at the front end N11 of the shunt resistor R1 and the voltage value (e.g., 9.7 V) at the rear end N12, that is, the voltage value (0.3 V) caused by the voltage drop (↓) of the shunt resistor R1.

In S200, the slave BMS 200 may calculate the first current amount based on the voltage value caused by the voltage drop (↓) of the shunt resistor R1 and the resistance of the shunt resistor R1 (S230).

The slave control unit 270 may substitute (I=V/R) the resistance (e.g., 1 Ω) of the shunt resistor R1 and the voltage value (0.3 V) caused by the voltage drop (↓) of the shunt resistor R1 into Ohm's law and may calculate the first current amount (I = 0.3 V/1 Ω = 300 mA). The resistance of the shunt resistor R1 may be stored in the slave storage unit 230.

According to the above-noted method, the second to fifth slave BMSs 200_2 to 200_5 may respectively calculate the first current amounts. For example, the first current amounts of the second to fifth slave BMS 200_2 to 200_N may be 240 mA, 180 mA, 120 mA, and 60 mA.

In S200, the slave BMS 200 may allocate the communication ID that corresponds to the first current amount as the communication ID of the slave BMS 200 based on the communication ID allocating table (S250). Here, as expressed in Table 1, the communication ID allocating table may include a plurality of communication IDs that correspond to a plurality of first current amounts (11 to I5).

The master BMS 100 may receive the calculated first current amounts and the allocated communication IDs from the slave BMSs 200_1 to 200_N, and may verify the allocated communication IDs (S300).

For example, the master BMS 100 may receive the first current amount of 330 mA and the second communication ID (ID_2) from the second slave BMS 200_2, and may compare them with the communication ID allocating table to verify the second communication ID. Referring to Table 1, the first current amount corresponding to the second communication ID (ID_2) is 240 mA. This is different from the first current amount 330 mA and the communication ID (ID_2) received from the second slave BMS 200_2. The master BMS 100 may determine the allocation of communication IDs performed by the second slave BMS 200_2 to have errors.

When the allocation of communication IDs by at least one of the slave BMSs 200_1 to 200_N is found to be erroneous, the master BMS 100 may broadcast an instruction for instructing allocation of communication IDs to the slave BMSs 200_1 to 200_N.

## Claims

1. A system for allocating communication IDs comprising:
a plurality of slave battery management systems(200_1, 200_2, ..., 200_N), BMSs, sequentially connected to a power line (Ls) for supplying power, and allocating predetermined communication IDs based on first current amounts applied through the power line to enter each of the slave BMSs,
wherein each of the slave BMSs is configured to consume a current amount (I_{cc}) through the power line for driving and output a second current amount that is the first current amount applied thereto, minus the consumed current amount, and that is the first current amount applied to the slave BMS next in line in the BMS sequence;
wherein each slave BMS includes:
a shunt resistor (R₁) coupled in series to the power line;
a slave storage (230) for storing information for indicating resistance of the shunt resistor and a communication ID allocating table in which a plurality of communication IDs correspond to a plurality of first current amounts are recorded; and
a slave controller (270) for measuring voltages at a front end and a rear end of the shunt resistor to calculate a voltage value caused by a voltage drop, calculating the first current amount based on the voltage value and resistance of the shunt resistor, and allocating a communication ID based on the calculated first current amount and the communication ID allocating table,
wherein the system further comprises
a master BMS (100) including the communication ID allocating table in which a plurality of communication IDs corresponding to a number of the slave BMSs and the first current amounts are recorded into a signal for instructing allocation of the communication IDs and broadcasting the same,
the master BMS being configured to receive the calculated first current amounts and the allocated communication ID from the slave BMSs, and compares the received first current amounts and the received communication IDs and the communication ID allocating table to verify allocation of communication IDs of the slave BMSs.

2. The system of claim 1, wherein
each of the slave BMSs further includes a slave communicator (210) for communicating with the master BMS and receiving the signal, and
the slave controller is configured to measure voltages at a front end and a rear end of the shunt resistor and calculate the first current amount upon receiving the signal through the slave communicator.

3. The system of claim 2, wherein
each of the slave controller is configured to allocate the communication ID that corresponds to the calculated first current amount as the communication ID of the slave controller based on the communication ID allocating table.

4. The system of claim 1, wherein
the communication ID is an ID for controller area network, CAN, communication.

5. The system of claim 1, wherein
the master BMS is operable by a power source for supplying the power to the slave BMSs.

6. A method for allocating communication IDs of a plurality of slave battery management systems, BMSs, sequentially connected to a power line for supplying power based on first current amounts applied through the power line to each of the slave BMSs, comprising
allowing the slave BMSs to allocate predetermined communication IDs as communication IDs of the slave BMSs based on the first current amounts,
wherein each of the slave BMSs consumes a current amount through the power line for driving and outputs a second current amount that is the first current amount applied thereto minus the consumed current amount, and that is the first current amount applied to the slave BMS next in line in the BMS sequence,
wherein
the allocating of predetermined communication IDs as communication IDs of the slave BMSs based on the first current amount includes:
measuring voltages at a front end and a rear end of a shunt resistor coupled in series to the power line and calculating a voltage value caused by a voltage drop;
calculating the first current amount based on the voltage value and resistance of the shunt resistor; and
allocating the communication ID that corresponds to the calculated first current amount as the communication of the slave BMS ID based on a communication ID allocating table in which a plurality of communication IDs corresponding to a plurality of first current amounts are recorded,
wherein the method further comprises,
after the allocating of predetermined communication IDs as communication IDs of the slave BMSs based on the first current amount,
allowing a master BMS to receive the calculated first current amount and the allocated communication ID from the slave BMSs, and verify allocation of communication IDs of the respective slave BMSs.

## Patentansprüche

1. System zum Zuweisen von Kommunikation-IDs, umfassend:
eine Mehrzahl von Slave-Batterieverwaltungssystemen (200_1, 200_2, ..., 200_N), BMSs, welche sequentiell mit einer Leistungsleitung (Ls) zum Liefern von Leistung verbunden sind, und welche vorbestimmte Kommunikation-IDs auf Grundlage von ersten Strommengen zuweisen, welche durch die Leistungsleitung angelegt werden, um in jedes der Slave-BMSs einzutreten,
wobei jedes der Slave-BMSs dazu eingerichtet ist, eine Strommenge (I_{cc}) durch die Leistungsleitung für einen Betrieb zu verbrauchen und eine zweite Strommenge auszugeben, welche die erste daran angelegte Strommenge ist, minus die verbrauchte Strommenge, und welche die erste Strommenge ist, welche an das Slave-BMS als nächstes in der Reihe der BMS-Sequenz angelegt wird;
wobei jedes Slave-BMS umfasst:
einen Neben-Widerstand (R₁), welcher in Reihe mit der Leistungsleitung gekoppelt ist;
einen Slave-Speicher (230) zum Speichern von Informationen für ein Anzeigen eines Widerstands des Neben-Widerstands und einer Kommunikation-ID-Zuweisungstabelle, in welcher eine Mehrzahl von Kommunikation-IDs entsprechend einer Mehrzahl von ersten Strommengen aufgezeichnet sind; und
eine Slave-Steuereinheit (270) zum Messen von Spannungen an einem vorderen Ende und einem hinteren Ende des Neben-Widerstands zum Berechnen eines Spannungswerts, welcher durch einen Spannungsabfall hervorgerufen wird, Berechnen der ersten Strommenge auf Grundlage des Spannungswerts und Widerstands des Neben-Widerstands, und Zuweisen einer Kommunikation-ID auf Grundlage der berechneten ersten Strommenge und der Kommunikation-ID-Zuweisungstabelle,
wobei das System ferner umfasst:
ein Master-BMS (100), welches die Kommunikation-ID-Zuweisungstabelle umfasst, in welcher eine Mehrzahl von Kommunikation-IDs entsprechend einer Anzahl der Slave-BMSs und der ersten Strommengen in ein Signal zum Anweisen einer Zuweisung der Kommunikation-IDs und übertragen derselben aufgezeichnet sind, wobei das Master-BMS dazu eingerichtet ist, die berechneten ersten Strommengen und die zugewiesene Kommunikation-ID von den Slave-BMSs zu erhalten, und die erhaltenen ersten Strommengen und die erhaltenen Kommunikation-IDs und die Kommunikation-ID-Zuweisungstabelle vergleicht, um die Zuweisung von Kommunikation-IDs der Slave-BMSs zu verifizieren.

2. System nach Anspruch 1, wobei
jedes der Slave-BMSs ferner ein Slave-Kommunikationselement (210) zum Kommunizieren mit dem Master-BMS und erhalten des Signals umfasst, und die Slave-Steuereinheit dazu eingerichtet ist, Spannungen an einem vorderen Ende und einem hinteren Ende des Neben-Widerstands zu messen und die erste Strommenge auf ein Erhalten des Signals durch das Slave-Kommunikationselement hin zu berechnen.

3. System nach Anspruch 2, wobei
jedes der Slave-Steuereinheit dazu eingerichtet ist, die Kommunikation-ID zuzuweisen, welche der berechneten ersten Strommenge entspricht, als die Kommunikation-ID der Slave-Steuereinheit auf Grundlage der Kommunikation-ID-Zuweisungstabelle.

4. System nach Anspruch 1, wobei
die Kommunikation-ID eine ID für eine Controller Area Network, CAN, Kommunikation ist.

5. System nach Anspruch 1, wobei
das Master-BMS durch eine Leistungsquelle zum Liefern der Leistung zu den Slave-BMSs betreibbar ist.

6. Verfahren zum Zuweisen von Kommunikation-IDs einer Mehrzahl von Slave-Batterieverwaltungssystemen, BMSs, welche sequentiell mit einer Leistungsleitung für ein Liefern von Leistung auf Grundlage von ersten Strommengen verbunden sind, welche durch die Leistungsleitung an jedes der Slave-BMSs angelegt werden, umfassend:
Erlauben der Slave-BMSs, vorbestimmte Kommunikation-IDs als Kommunikation-IDs der Slave-BMSs auf Grundlage der ersten Strommengen zuzuweisen,
wobei jedes der Slave-BMSs eine Strommenge durch die Leistungsleitung für einen Betrieb verbraucht und eine zweite Strommenge ausgibt, welche die erste daran angelegte Strommenge ist, minus die verbrauchte Strommenge, und welche die erste Strommenge ist, welche an das Slave-BMS als nächstes in der Reihe der BMS-Sequenz angelegt wird,
wobei
die Zuweisung von vorbestimmten Kommunikation-IDs als Kommunikation-IDs der Slave-BMSs auf Grundlage der ersten Strommenge umfasst:
Messen von Spannungen an einem vorderen Ende und einem hinteren Ende eines Neben-Widerstands, welcher in Reihe mit der Leistungsleitung gekoppelt ist, und Berechnen eines Spannungswerts, welcher durch einen Spannungsabfall hervorgerufen wird,
Berechnen der ersten Strommenge auf Grundlage des Spannungswerts und Widerstands des Neben-Widerstands; und
Zuweisen der Kommunikation-ID, welche der berechneten ersten Strommenge entspricht, als die Kommunikation der Slave-BMS-ID auf Grundlage einer Kommunikation-ID-Zuweisungstabelle, in welcher eine Mehrzahl von Kommunikation-IDs entsprechend einer Mehrzahl von ersten Strommengen aufgezeichnet sind,
wobei das Verfahren ferner umfasst:
nach dem Zuweisen von vorbestimmten Kommunikation-IDs als Kommunikation-IDs der Slave-BMSs auf Grundlage der ersten Strommenge,
Erlauben eines Master-BMS, die berechnete erste Strommenge und die zugeordnete Kommunikation-ID von den Slave-BMSs zu erhalten und eine Zuweisung von Kommunikation-IDs der entsprechenden Slave-BMSs zu verifizieren.

## Revendications

1. Système pour l'attribution d'ID de communication comprenant :
une pluralité de systèmes de gestion de batterie esclaves (200_1, 200_2, ..., 200_N), BMS, reliés de manière séquentielle à une ligne d'alimentation (Ls) pour l'alimentation en énergie, et l'attribution d'ID de communication prédéterminés sur la base de premières quantités de courant appliquées à travers la ligne d'alimentation pour accéder à chacun des BMS esclaves,
dans lequel chacun des BMS esclaves est configuré pour consommer une quantité de courant (I_{cc}) à travers la ligne d'alimentation pour le pilotage et délivrer en sortie une seconde quantité de courant, qui est la première quantité de courant appliquée à celui-ci moins la quantité de courant consommée, et qui est la première quantité de courant appliquée au BMS esclave suivant en ligne dans la séquence de BMS ;
dans lequel chaque BMS esclave comprend :
une résistance shunt (R₁) couplée en série à la ligne d'alimentation ;
un dispositif de stockage esclave (230) pour le stockage d'informations pour indiquer une résistance de la résistance shunt et une table d'attribution d'ID de communication dans laquelle une pluralité d'ID de communication correspondant à une pluralité de premières quantités de courant est enregistrée ; et
un dispositif de commande esclave (270) pour la mesure de tensions à une extrémité avant et une extrémité arrière de la résistance shunt pour calculer une valeur de tension provoquée par une chute de tension, le calcul de la première quantité de courant sur la base de la valeur de tension et la résistance de la résistance shunt, et l'attribution d'un ID de communication sur la base de la première quantité de courant calculée et de la table d'attribution d'ID de communication,
dans lequel le système comprend en outre
un BMS maître (100) comprenant la table d'attribution d'ID de communication dans laquelle un pluralité d'ID de communication correspondant à un nombre des BMS esclaves et aux premières quantités de courant est enregistrée dans un signal pour ordonner une attribution des ID de communication et les diffuser,
le BMS maître étant configuré pour recevoir les premières quantités de courant calculées et les ID de communication attribués à partir des BMS esclaves, et comparer les premières quantités de courant reçues et les ID de communication reçus et la table d'attribution d'ID de communication pour vérifier une attribution d'ID de communication aux BMS esclaves.

2. Système selon la revendication 1, dans lequel
chacun des BMS esclaves comprend en outre un dispositif de communication esclave (210) pour la communication avec le BMS maître et la réception du signal, et
le dispositif de commande esclave est configuré pour mesurer des tensions à une extrémité avant et une extrémité arrière de la résistance shunt et calculer la première quantité de courant à la réception du signal par l'intermédiaire du dispositif de communication.

3. Système selon la revendication 2, dans lequel
chacun des dispositifs de commande esclaves est configuré pour attribuer l'ID de communication qui correspond à la première quantité de courant calculée comme l'ID de communication du dispositif de commande esclave sur la base de la table d'attribution d'ID de communication.

4. Système selon la revendication 1, dans lequel
l'ID de communication est un ID pour une communication par réseau local de commande, CAN.

5. Système selon la revendication 1, dans lequel
le BMS maître est utilisable par une source d'énergie pour alimenter en énergie les BMS esclaves.

6. Procédé d'attribution d'ID de communication d'une pluralité de systèmes de gestion de batterie esclaves, BMS, reliés de manière séquentielle à une ligne d'alimentation pour l'alimentation en énergie sur la base de premières quantités de courant appliquées à travers la ligne d'alimentation à chacun des BMS esclaves, comprenant
l'autorisation pour les BMS esclaves d'attribuer des ID de communication prédéterminés comme des ID de communication des BMS esclaves sur la base des premières quantités de courant,
dans lequel chacun des BMS esclaves consomme une quantité de courant à travers la ligne d'alimentation pour le pilotage et délivre en sortie une seconde quantité de courant, qui est la première quantité de courant appliquée à celui-ci moins la quantité de courant consommée, et qui est la première quantité de courant appliquée au BMS esclave suivant en ligne dans la séquence de BMS,
dans lequel
l'attribution d'ID de communication prédéterminés comme des ID de communication des BMS esclaves sur la base de la première quantité de courant comprend :
la mesure de tensions à une extrémité avant et une extrémité arrière d'une résistance shunt couplée en série à la ligne d'alimentation et le calcul d'une valeur de tension provoquée par une chute de tension ;
le calcul de la première quantité de courant sur la base de la valeur de tension et la résistance de la résistance shunt ; et
l'attribution de l'ID de communication qui correspond à la première quantité de courant calculée comme l'ID de communication du BMS esclave sur la base d'une table d'attribution d'ID de communication dans laquelle une pluralité d'ID de communication correspondant à une pluralité de premières quantités de courant est enregistrée,
dans lequel le procédé comprend en outre,
après l'attribution d'ID de communication prédéterminés comme des ID de communication des BMS esclaves sur la base de la première quantité de courant, l'autorisation pour le BMS maître de recevoir la première quantité de courant calculée et l'ID de communication attribué à partir des BMS esclaves, et vérifier l'attribution d'ID de communication des BMS esclaves respectifs.
